# EUROPEAN PATENT APPLICATION

(11) **EP 3 663 433 A1**
(43) Date of publication of application: **10.06.2020**
(21) Application number: 18210184.0
(22) Date of filing: 04.12.2018
(51) Int. Cl.: C23C 16/40, C23C 16/455

(54) **METHOD AND SYSTEM FOR DEPOSITING A P-TYPE OXIDE LAYER ON A SUBSTRATE**

(71) Applicant: Nederlandse Organisatie voor toegepast- natuurwetenschappelijk onderzoek TNO, 2595 DA 's-Gravenhage (NL)
(72) Inventor: Frijters, Cornelis Henrikus, 2595 DA's-Gravenhage (NL); Poodt, Paulus Willibrordus George, 2595 DA 's Gravenhage (NL); Sengrian, Aprizal Akbar, 2595 DA's-Gravenhage (NL)
(74) Representative: V.O.

(57) **Abstract**

A method and system for depositing an atomic layer on a substrate. The method performs one or more method cycles to form a p-type oxide layer, wherein a method cycle includes performing successively the steps of: exposing the substrate to a Sn(IV) or Cu(II) precursor gas, exposing the substrate to an oxygen donor gas, wherein prior to and/or after exposing the substrate to the oxygen donor gas, hydrogen radicals are exposed to the substrate.

## Description

### FIELD OF THE INVENTION

The invention relates to a method and system for depositing an atomic layer on a substrate, wherein a semiconductor p-type oxide layer is formed by performing one or more method cycles. The invention further relates to a semiconductor device to which the p-type oxide layer is applied.

### BACKGROUND TO THE INVENTION

N-type and p-type semiconductors are widely used in the semiconductor industry. In n-type semiconductors, electrons are the majority carriers and holes are the minority carriers, while in p-type semiconductors, holes are the majority carriers and electrons are the minority carriers. Oxide semiconductors are becoming more and more established, for instance as a channel material in thin-film transistors (TFT) for e.g. display applications. While n-type oxides are common, p-type oxides are more rare, often have less than perfect electrical properties and are rather rarely explored due to the limitations in reliable methods to prepare these materials. However, since many electronic applications require devices such as p-n junctions and complementary metal oxide semiconductor (CMOS) architectures, it is important that a reliable fabrication method for p-type oxide semiconductors becomes available.

The deposition of p-type SnO (tin-oxide) can be performed by means of widely known sputtering methods, using SnO targets. Wet-chemical methods are also known. Atomic layer deposition (ALD) may provide significant advantages over sputtering and wet-chemical methods, for instance resulting in better material properties of deposited layers. Moreover, the layer thickness may more accurately be controlled by means of ALD.

In order to make an oxide layer by ALD, a substrate is sequentially exposed to: a metal-organic precursor, and an oxidant precursor (such as for instance H₂O, O₃, O-plasma, etc.). Sn(II) precursors have been used to make Sn(IV)O₂ films as these precursor are readily oxidized to Sn(IV) species. Document WO2016109118 (A1) describes ALD in which SnO is applied on a substrate using Sn(II) precursors and a range of oxidant precursors. By exposing the substrate to a Sn(II) precursor, such as for example Sn(dmamp)2, followed by exposure to an oxidant precursor, a Sn(II)O layer can be formed if care is taken not to further oxidize the precursor.

However, the use of Sn(II) precursors can result in a number of disadvantages. Though p-type Sn(II)O layers can be made by ALD using Sn(II) precursors, these precursors have relatively low vapor pressures and reactivities. Moreover, it can be difficult to apply Sn(II) precursors on relatively large surfaces of the substrate, which can limit the possibilities of upscaling.

There is a need to obtain an improved method and system for depositing a p-type oxide atomic layer on a semiconductor substrate.

### SUMMARY OF THE INVENTION

It is an object of the invention to provide for a method and a system that obviates at least one of the above mentioned drawbacks.

Additionally or alternatively, it is an object of the invention to provide for a method and system with a higher throughput.

Additionally or alternatively, it is an object of the invention to provide for a method and system with improved upscaling possibilities for depositing the p-type oxide layer on large areas of the substrate.

Thereto, the invention provides for a method for depositing an atomic layer on a substrate, the method performing one or more method cycles to form a semiconductor p-type oxide layer on the substrate, wherein a method cycle includes performing successively the steps of: exposing the substrate to a Sn(IV) or a Cu (II) precursor gas so as to deposit an atomic layer comprising respectively Sn(IV) or Cu(II) on the substrate, and exposing the substrate to an oxygen donor gas. Additionally, hydrogen radicals are exposed to the substrate prior to and/or after exposing the substrate to the oxygen donor gas such as to provide reduction of Sn(IV) to Sn(II) or Sn(0), respectively reduction of Cu(II) to Cu(I) or Cu(0).

The invention provides for a reliable way to create a p-type Sn oxide layer. Instead of using a Sn(II) precursor, a Sn(IV) precursor is used in the one or more method cycles. Typically, if a Sn(IV) precursor is used followed by an oxygen donor, a Sn(IV)O₂ layer is formed on the substrate. This is a n-type oxide layer. However, by employing the additional step of exposing hydrogen radicals to the thus formed Sn(IV)O₂ layer, Sn(II)O can be formed on the substrate. Hence, a p-type oxide layer can be obtained in an advantageous way, starting from a Sn(IV) precursor. Hydrogen radicals H⁺ (reactive, having free electrons) have been found capable of causing reduction of Sn⁴⁺ to Sn²⁺. Sn(II) may be further converted to Sn(0).

Similarly, the invention provides for a reliable way to create a p-type Cu oxide layer. Instead of using a Cu(I) precursor, a Cu(II) precursor is used in the one or more method cycles. Typically, if a Cu(II) precursor is used followed by an oxygen donor, a Cu(II)O layer is formed on the substrate. This is a n-type oxide layer. However, by employing the additional step of exposing hydrogen radicals to the thus formed Cu(II)O layer, Cu(I)O can be formed on the substrate. Hence, a p-type oxide layer can be obtained in an advantageous way, starting from a Cu(II)O precursor. Hydrogen radicals H⁺ (reactive, having free electrons) have been found capable of causing reduction of Cu²⁺ to Cu⁺. Cu(I) may be further converted to Cu(0).

It will be appreciated that Cu(II)O and Cu2(I)O are both p-type semiconductors, but Cu2(I)O has a much higher hole mobility.

The use of a Sn(IV) precursor may provide improved upscaling possibilities for the method. Sn(IV) precursors are often more common and easily obtainable compared to Sn(II) precursors. Furthermore, Sn(IV) precursors compared to Sn(II) precursors are often easier to evaporate, they are more volatile and have a higher vapour pressure, so that they can more easily be dosed as a gas phase compound into the system in larger quantities and/or higher concentrations, which can be advantageous for scaling up the method. Sn(IV) has a higher vapor pressure and reactivities as compared to Sn(II), making it more advantageous in terms of upscaling ALD of Sn(II)O layers to large areas and obtaining a high throughput.

Hence, instead of using a Sn(II) or a Cu(I) precursor, a Sn(IV) respectively a Cu(II) precursor may be used in the one or more method cycles for depositing the atomic layer on the substrate. This atomic layer deposition (ALD) can be advantageous for forming thin p-type oxide layers on a semiconductor substrate. The substrate can be exposed to the Sn(IV) respectively Cu(II) precursor with the purpose of depositing a layer of an Sn(IV) respectively Cu(II) compound of the precursor gas on the substrate. Further, this Sn(IV) compound respectively Cu(II) comprising layer that has been deposited on the substrate can be exposed to the oxygen donor (e.g. oxidant precursor) with the purpose of forming an Sn-oxide, respectively Cu-oxide layer in the Sn(IV) respectively Cu(II) compound layer. By additionally supplying hydrogen radicals prior to and/or after exposing the substrate to the oxygen donor, the deposited Sn(IV), respectively Cu(II) compound layer can be reduced to a resultant Sn(II) respectively Cu(I) layer, resulting in the p-type oxide layer on the semiconductor substrate. The advantages linked to the use of a Sn(IV) respectively Cu(II) precursor in an ALD process can therefore be obtained, by performing a reduction step in the method cycle.

The additional step of exposing the Sn(IV) respectively Cu(II) containing layer that has been deposited on the substrate to hydrogen radicals can be used either before the oxygen donor is supplied to the substrate or after the oxygen donor is supplied to the substrate. Advantageously, in both cases, a p-type Sn(II) oxide respectively Cu(I) oxide layer is obtained.

Optionally, a plurality of method cycles are performed consecutively until a desired layer thickness of the Sn(II) oxide respectively Cu(I) oxide layer is obtained. By employing ALD, the layer thickness can be more easily controlled.

Each layer of Sn(IV) oxide, respectively Cu(II) oxide formed on the substrate can be reduced in a controlled manner to Sn(II) oxide respectively Cu(I) oxide, during the method cycle. The amount of hydrogen or generated hydrogen radicals (cf. concentration) provided to the formed layer on the substrate can be controlled.

It will be appreciated that a Sn(IV) precursor can be considered as a precursor gas containing Sn(IV). An example of a Sn(IV) precursor is TDMA-Sn. Similarly, it will be appreciated that a Cu(II) precursor can be considered as a precursor gas containing Cu(II). An oxygen donor gas can be considered as a precursor gas containing an oxygen donor, such as for example an oxidant precursor gasses O₂, O₃, H₂0, etc.

Optionally, hydrogen radicals are exposed to the substrate by means of a H₂ containing plasma.

The exposure of H₂-plasma to the deposited film on the substrate can effectively reduce the Sn(IV) species on the substrate to Sn(II) species that make up the Sn(II)O layers, or reduce the Cu(II) species on the substrate to Cu(I) species that make up the Cu(I)₂O layers.

The method of this invention can thus lead to a monolayer-by-monolayer reduction of Sn(IV) species to Sn(II) species, respectively to a monolayer-by-monolayer reduction of Cu(II) species to Cu(I) species. Advantageously, a p-type Sn(II) oxide (SnO) can be obtained by means of atomic layer deposition using common Sn(IV) precursors and oxygen donors, and a p-type Cu(I) oxide can be obtained by means of atomic layer deposition using common Cu(II) precursors.

Optionally, in a method cycle, first a Sn(IV) precursor, respectively a Cu(II) precursor is exposed to the substrate, wherein subsequently an oxygen donor is exposed to the layer formed by exposure of the substrate to the Sn(IV) precursor respectively Cu(II) precursor, and wherein subsequently, hydrogen radicals are exposed to the thus formed Sn-oxide layer. The hydrogen radicals may be provided by means of a H₂ plasma.

Optionally, at least one purging step is carried out in the method cycle. The purging step can be carried out between successive method steps in the method cycle, for example after exposure of the substrate to the Sn(IV) precursor respectively the Cu(II) precursor and prior to exposing the formed layer of Sn(IV) respectively Cu(II) on the substrate with the hydrogen radicals. The purging step can for instance be carried out using an inert gas, for example N₂.

Optionally, a non-oxidizing oxygen donor gas is used if the H₂ plasma is exposed prior to exposure to the oxygen donor gas. By using a non-oxidizing oxygen donor, there is a minimal risk to oxidization of the Sn(II) respectively the Cu(I) formed on the substrate. The Sn(II) respectively the Cu(I) can adsorb oxygen, without being oxidized to a higher valence.

Optionally, in a method cycle, first a Sn(IV) precursor is exposed to the substrate, thereafter hydrogen radicals are exposed to the layer formed by exposure to the Sn(IV) precursor on the substrate to form a Sn(II) containing layer, and subsequently, a non-oxidizing oxygen donor is exposed to the thus formed Sn(II)- layer to form a Sn(II)-oxide layer on the substrate. The hydrogen radicals may be provided by means of a H₂ plasma.

The p-type Sn(II) oxide layer formed on the substrate can be obtained by performing a sequence of steps in a method cycle of an ALD process. In a first step, a Sn(IV) layer can be created by exposing a surface of the substrate with a Sn(IV) precursor. In a second step, hydrogen radicals are exposed to the Sn(IV) layer being formed in the first step. As a result of the second step, a Sn(II) layer is formed on the substrate. In a third step, an oxygen donor is exposed to the Sn(II) layer formed on the substrate. Preferably use is made of a non-oxidizing oxygen donor in order to minimize the risk to oxidation of the Sn(II) layer formed in the second step and conversion to a Sn(IV) layer. In this way, advantageously, the resultant layer on the substrate can be a p-type tin-monoxide layer (Sn(II)). It can thus be prevented that an oxidizing process occurs in which Sn(II) oxide is converted to Sn(IV) oxide.

Similarly, the p-type Cu(I) oxide layer formed on the substrate can be obtained by performing a sequence of steps in a method cycle of an ALD process. In a first step, a Cu(II) layer can be created by exposing a surface of the substrate with a Cu(II) precursor. In a second step, hydrogen radicals are exposed to the Cu(II) layer being formed in the first step. As a result of the second step, a Cu(I) layer is formed on the substrate. In a third step, an oxygen donor is exposed to the Cu(I) layer formed on the substrate. Preferably use is made of a non-oxidizing oxygen donor in order to minimize the risk to oxidation of the Cu(I) layer formed in the second step and conversion to a Cu(II) layer. In this way, advantageously, the resultant layer on the substrate can be a p-type copper oxide layer (Cu(I)). It can thus be prevented that an oxidizing process occurs in which Cu(I) oxide is converted to Cu(II) oxide.

A wide variety of oxygen donors are known to the skilled person and are suitable for use with the present invention, for example such as water, oxygen, ozone, etc. Whether oxidization will take place as a result of the exposure to the oxygen donor or not can depend on the thermodynamics. By proper choice of the precursor and the thermodynamics a non-oxidizing oxygen donor can be obtained. For instance, the temperature at which the process takes place, the type of donor and also the concentration of the donor are important parameters.

The non-oxidizing oxygen donor may be a precursor gas which under the ALD conditions is capable of forming a Sn-oxygen compound, without however oxidizing Sn(II)-ions to Sn(IV)-ions. The non-oxidizing oxygen donor may thus prevent that the Sn(II) oxide containing layer is converted to a Sn(IV) oxide containing layer.

If the exposure to hydrogen radicals is performed after exposure to the oxygen donor, a different situation may be presented. First a Sn(IV) layer is formed on the substrate by exposure to the Sn(IV) precursor. Then, as a result of subsequent exposure to the oxygen donor, the Sn(IV) layer is not further oxidized and remains a Sn(IV) layer. In the subsequent step of exposure to the hydrogen radicals the Sn(IV) is reduced to Sn(II). Hence, in this case, it may not be required to use a non-oxidizing oxygen donor. However, to provide a flexible process in which the order of the process steps may be varied, a non-oxidizing oxygen donor may nevertheless be used.

Optionally, the method further includes a step for converting formed Sn(0) or Cu(0) to Sn(II) or Cu(I), respectively. In an example, the deposited Sn(IV) is converted to Sn(0), which is subsequently converted to Sn(II). Similarly, the deposited Cu(II) can be converted to Cu(0), which is subsequently converted to Cu(I).

Optionally, the method includes one or more intermediate steps for reducing Sn(IV) to Sn(II) or Cu(II) to Cu(I). For instance, in addition to Sn(IV) → Sn(II), and Cu(II) → Cu(I), the method may include Sn(IV) → Sn(0) → Sn(II) or Cu(II) → Cu(0) → Cu(I). Other intermediate steps may also be possible, for instance, Sn(IV) → Sn(0) → Sn(II) → Sn(0) → Sn(II), or Cu(II) → Cu(0) → Cu(I) → Cu(0) → Cu(I).

Optionally, forming of the p-type oxide layer is performed at a temperature of about 250°C or lower. Preferably the method of this invention is carried out at a temperature which ranges between 100°C and 250°C.

Optionally, forming of the p-type oxide layer is performed under a pressure between 130 Pa and 650 kPa.

Optionally, the method further includes a step of subjecting the resultant atomic layer on the substrate including the p-type oxide layer to an annealing step, at a temperature between 100 to 250° Celsius, although a somewhat lower or a somewhat higher temperature may be used as well. In general the annealing step will be carried out for about 30 minutes to 2 hours, although a longer or a shorter annealing time may be selected in function of the envisaged properties. Properties of the formed layer on the substrate can be optimized by means of an anneal step.

Optionally, the oxygen donor gas is selected from the group consisting of oxygen (O₂), ozone (O₃), water (H₂O), hydrogen peroxide (H₂O₂), carbon dioxide (CO₂), carbon monoxide (CO), methanol (CH₃OH), ethanol (C2H₆OH), isopropyl alcohol (C₃H₇OH), nitric oxide (NO), nitrous oxide (N₂0), and combinations thereof.

According to an aspect, the invention also relates to a system for carrying out the method according to the invention.

According to an aspect, the invention relates to a system for depositing an atomic layer on a substrate. The system is configured to perform one or more method cycles to form a p-type oxide layer. The system comprises a deposition chamber with a substrate holder arranged therein, the substrate holder being configured to hold the substrate. Further, the deposition chamber includes at least one gas supply member, for example an opening through which gas can be supplied to and/or removed from the deposition chamber. The system further includes a controller arranged for controlling the system to successively carrying out in a method cycle the steps of: exposing through the at least one supply member the substrate to a Sn(IV) or a Cu (II) precursor gas, exposing through the at least one supply member the substrate to an oxygen donor gas, wherein hydrogen radicals are exposed to the substrate prior to and/or after exposing the substrate to the oxygen donor gas such as to provide reduction of Sn(IV) to Sn(II) or Sn(0), respectively Cu(II) to Cu(I) or Cu(0).

According to an aspect, the invention relates to a method for forming a semiconductor device by means of depositing an atomic layer on a substrate by performing a plurality of method cycles according to the invention.

According to an aspect, the invention relates to a semiconductor device to which a p-type oxide layer is applied, obtained by performing the method according to the invention.

Semiconductor devices can be made on substrates, such as silicon wafers or glass plates. Semiconductor devices may be used in computers, monitors, and the like. These devices are made by a sequence of fabrication steps, such as atomic layer deposition.

Atomic layer deposition can be performed in a low-pressure processing chamber. In chemical vapor deposition, a wafer or other substrate is loaded into a processing chamber and is exposed to a process gas under suitable conditions for deposition of the process gas or a component of the process gas in the form of a thin film on the wafer.

In atomic layer deposition, many thin film layers are deposited on the wafer in a repetitive process including a plurality of method cycles, in which the wafer is alternately exposed to more than one process gas. Each step of an ALD process entails opening and closing a number of valves which control the flow to the processing chamber of process gases or a purge gas.

It will be appreciated that any of the aspects, features and options described in view of the method apply equally to the system and the described semiconductor. It will also be clear that any one or more of the above aspects, features and options can be combined.

### BRIEF DESCRIPTION OF THE DRAWING

The invention will further be elucidated on the basis of exemplary embodiments which are represented in a drawing. The exemplary embodiments are given by way of non-limitative illustration. It is noted that the figures are only schematic representations of embodiments of the invention that are given by way of non-limiting example.

In the drawing:
- Fig. 1: shows a schematic diagram of a method cycle;
- Fig. 2: shows a schematic diagram of a method cycle;
- Fig. 3: shows a schematic diagram of a method cycle;
- Fig. 4: shows a schematic diagram of a method cycle;
- Fig. 5: shows a schematic diagram of a method cycle;
- Fig. 6: shows a schematic diagram of a method cycle; and
- Fig. 7: shows a schematic diagram of a method.

### DETAILED DESCRIPTION

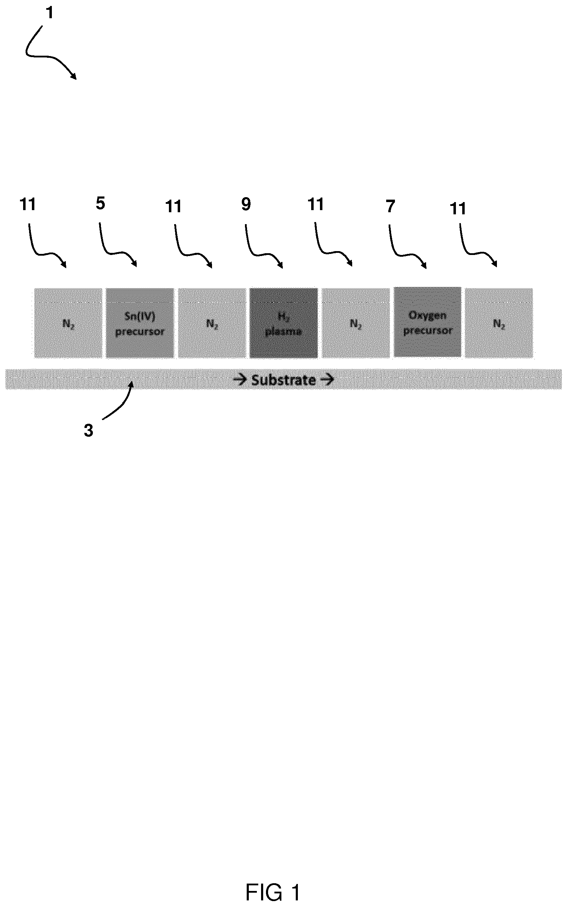

Fig. 1 shows a schematic diagram of a method cycle 1 in a method for depositing an atomic layer on a substrate 3. The method performs one or more method cycles to form a semiconductor p-type oxide layer on the substrate 3. The description hereafter will concentrate on the formation of a Sn oxide layer on the substrate. It shall however be clear to the skilled person that the given description is also valid for the deposition of a Cu oxide layer. A method cycle includes performing successively the steps of: exposing the substrate to a Sn(IV) precursor gas 5, exposing the substrate to an oxygen donor 7. Prior to exposing the substrate 3 to the oxygen donor 7, hydrogen radicals 9 are exposed to the substrate such as to provide reduction of Sn(IV) to Sn(II). By means of the hydrogen radicals 9 exposure, the valence of tin can be reduced from 4 to 2.

Between the atomic layer deposition steps in the method cycle, purging is carried out using N₂ gas 11. Advantageously, the N₂ gas will not react with the formed layer on the substrate. Other inert gasses may also be used for purging, for example helium, argon or neon or any other gas that is inert in the conditions prevailing in the system.

The p-type oxide layer can be fabricated using an atomic layer deposition (ALD) process. Using a Sn(IV) precursor in an ALD process, a mono-oxide tin layer can be obtained. Using a Cu(II) precursor in an ALD process, a mono-oxide copper layer can be obtained. Cu(II)O and Cu2(I)O are both mono-oxides. ALD allows i.a. better control over the thickness than other methods such as sputtering, such that an adequate homogenous layer thickness can be obtained. As a result, a lot of control over the properties of the deposited layer can be obtained.

Most tin precursors are Sn(IV) precursors. However, in the prior art Sn(II) precursors were used for obtaining a tin monoxide layer with ALD, because Sn(IV) precursors would have created a tin dioxide layer. According to the invention, a tin monoxide layer (Sn(II)) is obtained with (spatial) ALD using an Sn(IV), by using an additional step in which hydrogen radicals are exposed to the formed layer after the Sn(IV) precursor is exposed to the substrate. The hydrogen radicals can be obtained by employing a H₂ plasma. This step can be performed prior to or after the exposure of the formed layer on the substrate to an oxygen donor.

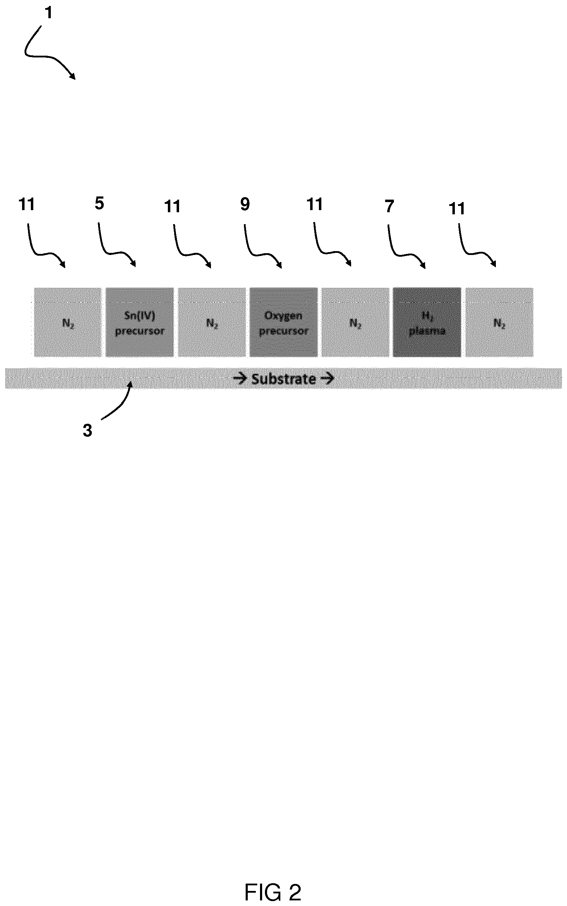

Fig. 2 shows a schematic diagram of a method cycle 1 in a method for depositing an atomic layer on a substrate 3. Similar to the example shown in fig. 1, the method performs one or more method cycles to form a semiconductor p-type oxide layer on the substrate 3. A method cycle includes performing successively the steps of: exposing the substrate to a Sn(IV) precursor gas 5, exposing the substrate to an oxygen donor 7. After exposure of the substrate 3 to the oxygen donor 7, hydrogen radicals 9 are exposed to the substrate such as to provide reduction of Sn(IV) to Sn(II). Also in this case, between the atomic layer deposition steps in the method cycle, purging is carried out using N₂ gas 11.

The sequence of the hydrogen exposure step and the oxygen donor step in a method cycle can thus be changed (cf. examples of fig. 1 and fig. 2). The oxygen donor step can depend on the sequence of steps. As discussed above, it may be desired to employ a non-oxidizing oxygen donor if the the H₂ plasma is exposed prior to exposure to the oxygen donor gas. Other variant sequences are also possible. For example, it will be appreciated that optionally, the hydrogen exposure step is employed prior to and after the oxygen donor step in the method cycle.

Though experimental results show that exposing hydrogen radicals to the substrate prior to or after exposing the substrate to the oxygen donor gas in both cases leads to a thin film containing Sn(II)O, as a result of the reduction of Sn(IV) to Sn(II), the first case (H2-plasma provided between Sn(IV)-precursor and oxygen precursor) may tend to give better results at least in some cases. The deposition process can be optimized. Experimental results show that tin oxide films with at least 60% Sn(II)O at the surface can be deposited. The formation of metallic tin can be substantially prevented.

P-type conductivity has been demonstrated in these films with a measured Hall mobility of up to 8 cm²/Vs and a carrier density of ∼1016 cm⁻³.

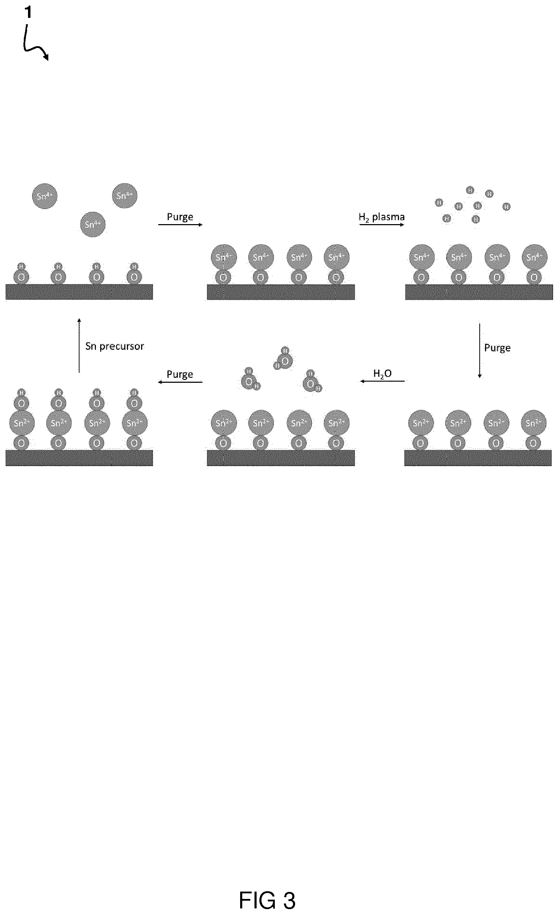

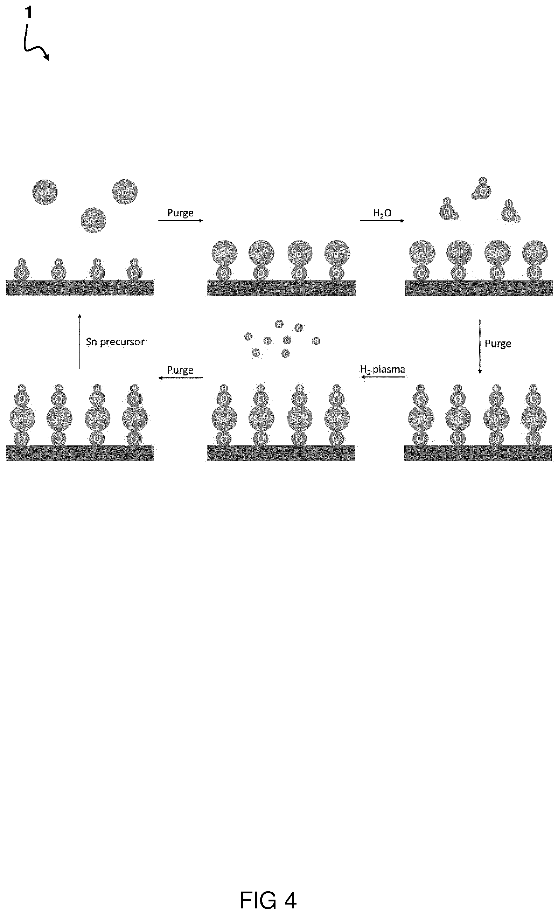

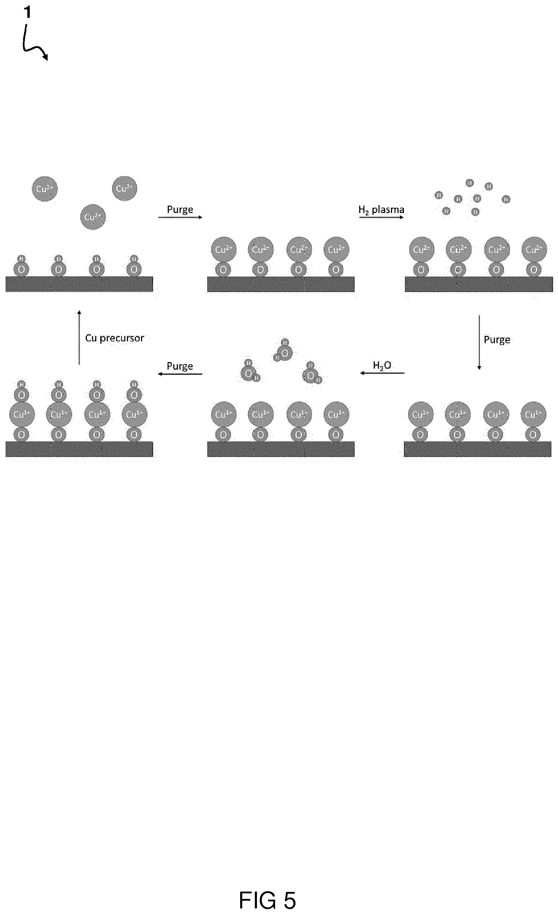

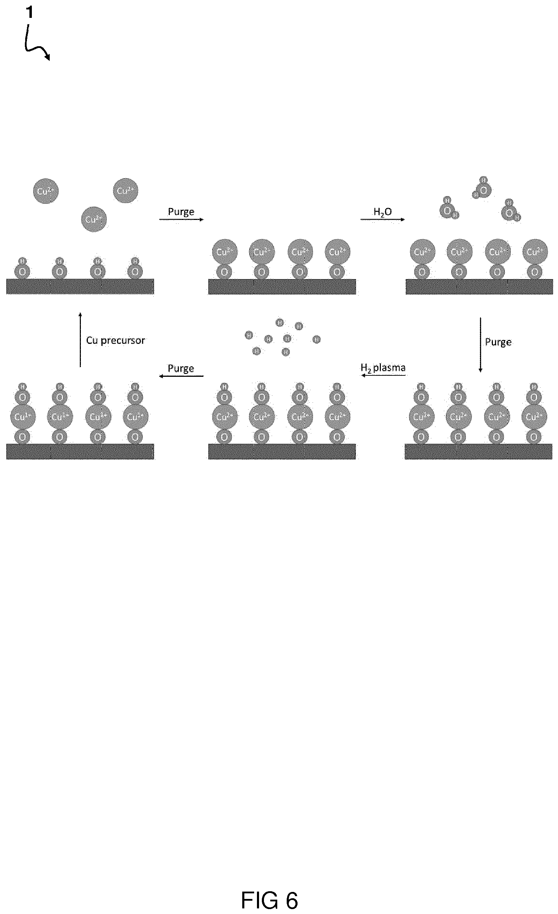

Fig. 3-6 show a schematic diagram of method cycles 1. In fig. 3, a SnO process is shown including a Sn precursor exposure step, a H2 plasma exposure step, and a H2O exposure step. In fig. 4 a SnO process is shown including a Sn precursor exposure, a H2O exposure step, and a H2 plasma exposure step. In fig. 5 a Cu2O process is illustrated, including a Cu precursor exposure step, a H2 plasma exposure step, and H2O exposure step. In fig. 6 a Cu2O process step is shown, including a Cu precursor exposure step, a H2O exposure step, and a H2 plasma exposure step.

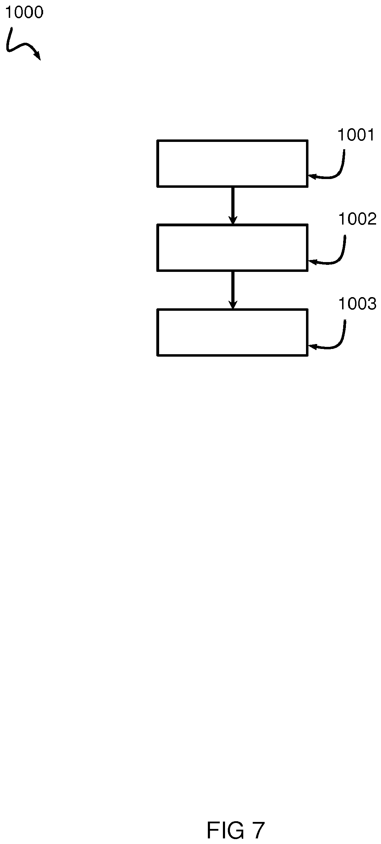

Fig. 7 shows a schematic diagram of a method 1000 for depositing an atomic layer on a substrate, the method performing one or more method cycles to form a semiconductor p-type oxide layer on the substrate, wherein a method cycle includes successive steps. In a first step 1001, a Sn(IV) or Cu(II) precursor gas is exposed to the substrate. In a second step 1002, an oxygen donor gas is exposed to the substrate. In a third step 1003, hydrogen radicals are exposed to the substrate prior to and/or after exposing the substrate to the oxygen donor gas such as to provide reduction of Sn(IV) to Sn(II) or Sn(0), or reduction of Cu(II) to Cu(I) or Cu(O), respectively.

The present inventors have recognized that a key to improving throughput and upscaling for ALD processes , lies in the use of Sn(IV) precursors for forming a thin film of Sn(II)O onto the substrate, wherein an exposure to hydrogen radicals is used for reduction of Sn(IV) to Sn(II) of the Sn-oxide compound of the formed layer on the substrate.

ALD is very advantageous for forming thin layers on a semiconductor substrate. Instead of using a Sn(II) precursor, gas, a Sn(IV) precursor gas can be used. Sn(IV) is more preferable because it i.a. provides a better scalability and moreover is more common than Sn(II). In order to obtain a p-type oxide layer starting from Sn(IV), an additional step is used in which hydrogen radicals are supplied towards the surface of the substrate. Hereby the Sn(IV) can be reduced to Sn(II). This additional step can be used either before the oxidant precursor is added or after the oxidant precursor is added. In both cases, a resultant p-type Sn(II) oxide layer will advantageously be obtained. A combination is also possible, wherein both prior to and after the oxygen donor is exposed, the hydrogen radicals are exposed to the formed layer on the substrate.

Herein, the invention is described with reference to specific examples of embodiments of the invention. It will, however, be evident that various modifications, variations, alternatives and changes may be made therein, without departing from the essence of the invention. For the purpose of clarity and a concise description features are described herein as part of the same or separate embodiments, however, alternative embodiments having combinations of all or some of the features described in these separate embodiments are also envisaged and understood to fall within the framework of the invention as outlined by the claims. The specifications, figures and examples are, accordingly, to be regarded in an illustrative sense rather than in a restrictive sense. The invention is intended to embrace all alternatives, modifications and variations which fall within the spirit and scope of the appended claims. Further, many of the elements that are described are functional entities that may be implemented as discrete or distributed components or in conjunction with other components, in any suitable combination and location.

In the claims, any reference signs placed between parentheses shall not be construed as limiting the claim. The word 'comprising' does not exclude the presence of other features or steps than those listed in a claim. Furthermore, the words 'a' and 'an' shall not be construed as limited to 'only one', but instead are used to mean 'at least one', and do not exclude a plurality. The mere fact that certain measures are recited in mutually different claims does not indicate that a combination of these measures cannot be used to an advantage.

## Claims

1. A method for depositing an atomic layer on a substrate, the method performing one or more method cycles to form a semiconductor p-type oxide layer on the substrate, wherein a method cycle includes performing successively the steps of:
exposing the substrate to a Sn(IV) or a Cu (II) precursor gas so as to deposit an atomic layer comprising Sn(IV) or respectively Cu(II) on the substrate,
exposing the substrate to an oxygen donor gas,
wherein hydrogen radicals are exposed to the substrate prior to and/or after exposing the substrate to the oxygen donor gas such as to provide reduction of Sn(IV) to Sn(II) or Sn(0), respectively reduction of Cu(II) to Cu(I) or Cu(0).

2. Method according to claim 1, wherein hydrogen radicals are provided by means of a H₂ containing plasma.

3. Method according to claim 1 or 2, wherein a non-oxidizing oxygen donor gas is used if the H₂ plasma is exposed prior to exposure to the oxygen donor gas.

4. Method according to claim 1, 2 or 3, further including a step for converting Sn(0) or Cu(0) to Sn(II) or Cu(I), respectively.

5. Method according to any one of the preceding claims, wherein exposing of the substrate to the oxygen donor gas and the hydrogen radicals is performed at a temperature of about 250°C or lower.

6. Method according to claim 5, wherein exposing of the substrate to the oxygen donor gas and the hydrogen radicals is performed at a temperature of between 100°C and 250°C.

7. Method according to any one of the preceding claims, wherein forming of the p-type oxide layer is performed under a pressure between 130 Pa and 650 kPa.

8. Method according to any one of the preceding claims, further comprising a step of subjecting the resultant atomic layer on the substrate including the p-type oxide layer to an annealing at a temperature between 100°C and 250°C.

9. Method according to the previous claim, wherein annealing is carried out for a period of time which ranges from 30 minutes to 2 hours.

10. Method according to any one of the preceding claims, wherein the oxygen donor precursor gas is selected from the group consisting of oxygen (O₂), ozone (O₃), water (H₂O), hydrogen peroxide (H₂O₂), carbon dioxide (CO₂), carbon monoxide (CO), methanol (CH₃OH), ethanol (C₂H₆OH), isopropyl alcohol (C₃H₇OH), nitric oxide (NO), nitrous oxide (N₂0) and combinations of two or more of the aforementioned compounds.

11. Method according to any one of the preceding claims, wherein a purging step with an inert gas, preferably N₂, is carried out after one or more of the steps of exposing the substrate to the Sn(IV) or the Cu(II) compound, exposing the substrate to an oxygen donor gas or exposing the substrate to hydrogen radicals .

12. A system for depositing an atomic layer on a substrate, the system configured to perform one or more method cycles to form a p-type oxide layer, the system comprising a deposition chamber with a substrate holder arranged therein, the substrate holder being configured to hold the substrate, wherein the deposition chamber includes at least one gas supply member through which gas can be supplied to and/or removed from the deposition chamber, wherein the system further includes a controller arranged for controlling the system to successively carrying out in a method cycle the steps of:
supplying a Sn(IV) or a Cu(II) precursor gas to the substrate, through the at least one gas supply member,
supplying through the at least one gas supply member an oxygen donor precursor gas to the substrate,
wherein hydrogen radicals are supplied to the substrate prior to and/or after exposing the substrate to the oxygen donor precursor gas such as to provide reduction of Sn(IV) to Sn(II) or Sn(0), respectively reduction of Cu(II) to Cu(I) or Cu(0).

13. A method for forming a semiconductor device by means of depositing an atomic layer on a substrate by performing a plurality of method cycles according to any one of the method claims 1-11.

14. A semiconductor device to which a p-type oxide layer is applied, obtained by performing the method according to any one of the claims 1-11.
